Europäisches Patentamt

(19) European Patent Office

Office européen des brevets

(11) Numéro de publication : **0 250 301 B1**

(12) **FASCICULE DE BREVET EUROPEEN**

(45) Date de publication du fascicule du brevet :
27.02.91 Bulletin 91/09

�Int. Cl.⁵ : **H03B 5/18**

(21) Numéro de dépôt : **87401323.8**

(22) Date de dépôt : **12.06.87**

(54) Oscillateur doubleur de fréquence, fonctionnant en hyperfréquences.

(30) Priorité : **13.06.86 FR 8608584**

(43) Date de publication de la demande :
**23.12.87 Bulletin 87/52**

(45) Mention de la délivrance du brevet :
**27.02.91 Bulletin 91/09**

(84) Etats contractants désignés :
**DE GB IT NL SE**

(56) Documents cités :
**IEEE TRANSACTIONS ON MICROWAVE
THEORY AND TECHNIQUES, vol. MTT-33, no.
12, décembre 1985, pages 1346-1349, IEEE,
New York, US; A.M. PAVIO et al.: "A 20-40-GHz
push-push dielectric resonator oscillator"
IEEE TRANSACTIONS ON MICROWAVE
THEORY AND TECHNIQUES, vol. MTT-33, no.
8, août 1985, pages 731-734, IEEE, New York,
US; A.K. TALWAR: "Ka-band FET oscillator"**

(56) Documents cités :
**16TH EUROPEAN MICROWAVE CONFE-
RENCE 86, Dublin, 8-12 septembre 1986,
pages 739-748, Microwave exhibitions and
publishers Ltd, Kent, GB; M. MAMODALY et
al.: "New configurations to reduce converted
FM noise in FET oscillators"**

(73) Titulaire : **THOMSON-CSF
51, Esplanade du Général de Gaulle
F-92800 Puteaux (FR)**

(72) Inventeur : **Mamodaly, Narguise
THOMSOM-CSF SCPI 19, avenue de Messine
F-75008 Paris (FR)**
Inventeur : **Colin, Pascal
THOMSOM-CSF SCPI 19, avenue de Messine
F-75008 Paris (FR)**
Inventeur : **Bert, Alain
THOMSOM-CSF SCPI 19, avenue de Messine
F-75008 Paris (FR)**
Inventeur : **Obregon, Juan
THOMSOM-CSF SCPI 19, avenue de Messine
F-75008 Paris (FR)**

(74) Mandataire : **Taboureau, James et al
THOMSON-CSF SCPI
F-92045 Paris La Défense Cédex 67 (FR)**

Jouve, 18, rue Saint-Denis, 75001 PARIS

**EP 0 250 301 B1**

## Description

La présente invention concerne un oscillateur hyperfréquence à faible bruit à proximité de la fréquence porteuse. Cet oscillateur est de type doubleur, c'est-à-dire que la fréquence délivrée sur la charge est double de la fréquence d'oscillation des transistors dans le montage dit "push-push". La diminution du bruit proche de la fréquence centrale est obtenue au moyen d'une impédance BF optimale placée entre les grilles des deux transistors, ce circuit soit mettant les sources de bruit non corrélées en série, soit empêchant les sources de bruit BF des transistors d'être mises à la masse.

Il est important pour les oscillateurs hyperfréquences actuels et futurs, qui travaillent à plusieurs dizaines de gigahertz, que la fréquence qu'ils délivrent dans une charge soit la plus pure possible, c'est-à-dire qu'il n'y ait pas d'oscillation parasite dans une bande de fréquences proches de la fréquence centrale, dite porteuse : par exemple dans une bande de 10 kHz autour de 20 GHz.

Différents moyens sont connus pour obtenir ce résultat. Ils varient selon le schéma de l'oscillateur considéré. Par exemple, dans un oscillateur à contre-réaction, on peut séparer la fonction de limitation et la fonction d'amplification, mais ce type d'oscillateur exige des transistors qui oscillent à 100 GHz si la porteuse est à 100 GHz. De tels transistors sont de dimensions très petites et manquent de puissance.

Le montage dit "push-push" (voir l'article de A.M. PAVIO et M.A. SMITH : "A 20-40 GHS push-push Dielectric Resonator Oscillator" paru dans IEEE TRANSACTIONS ON MICROWAVE THEORY AND TECHNIQUES, vol. MTT-33, no. 12, décembre 1985, pages 1346-1349), utilisé dans l'invention, a l'avantage de ne nécessiter que deux transistors qui oscillent à 50 GHz si l'on veut obtenir une porteuse à 100 GHz. Dans ce montage, les deux transistors sont montés en parallèle, et leurs grilles sont réunies à deux microbandes, parallèles entre elles, entre lesquelles est positionné un résonateur diélectrique céramique. Les microbandes sont mises à la masse à travers une résistance, classiquement 50Ω. Si l'on considère chaque transistor pris séparément, le circuit résonant microbande + résonateur diélectrique est bien connu, mais chacun des deux circuits résonants n'annule pas le bruit basse fréquence propre aux transistors.

Selon l'invention, les sources de bruits basses fréquences non correlées des transistors à effet de champ sont :

– soit chargées sur une impédance infinie au moyen d'une capacité de forte valeur placée entre l'extrémité de la microbande de grille et la résistance mise à la masse. Cette capacité empêchant la mise à la masse des sources de bruit BF entraine une diminution du bruit FM à l'harmonique 2,

– soit mises en série au moyen d'une self qui réunit entre elles les deux microbandes de grilles des transistors, cette self étant soudée en des points, situés entre le résonateur diélectrique et l'extrémité de la microbande réunie à une résistance, tels que le bruit basse fréquence autour de l'harmonique 2, dans la charge, est diminué, et éloigné de la porteuse. Les sources de bruits basses fréquences des transistors peuvent être mises en série parce qu'un condensateur, pour chaque microbande, est interposé entre l'extrémité de la microbande et la résistance mise à la masse : la valeur de ces condensateurs est assez grande pour qu'en hyperfréquences ils soient équivalents à un court circuit et que pour les basses fréquences ils soient équivalents à un circuit ouvert et que la selg précédente réunit les deux grilles d'un point de vue basse fréquence.

De façon plus précise, l'invention concerne un oscillateur doubleur de fréquence, fonctionnant en hyperfréquences, comportant, dans un montage dit "push-push", deux transistors à effet de champ travaillant en parallèle, dont les électrodes de sources et drains sont connectées à des impédances, la charge d'utilisation étant connectée en un point commun aux impédances des électrodes de sortie des deux transistors, dont les grilles sont connectées, pour chaque transistor, par une impédance, à une première extrémité d'une ligne microbande dont la seconde extrémité est mise à la masse par une résistance, un résonateur diélectrique étant placé entre les deux lignes microbandes en un point tel que l'oscillation est obtenue, cet oscillateur étant caractérisé en ce que, en vue de diminuer le bruit basse fréquence dans la charge aux environs de la fréquence principale, dite porteuse, les sources de bruit propres aux transistors sont isolées de la masse en courant continu, et chargées par une impédance basse fréquence de valeur infinie, constituée par deux capacités de forte valeur, chacune de ces deux capacités étant interposée entre la seconde extrémité d'une ligne microbande et sa résistance de mise à la masse.

L'invention sera mieux comprise par la description plus détaillée d'un exemple d'application, en s'appuyant sur les figures jointes en annexe, qui représentent :

– figure 1 : schéma simplifié d'un oscillateur push-push selon l'art connu,

– figure 2 : schéma électrique d'un oscillateur selon l'invention,

– figure 3 : schéma de réalisation de l'oscillateur selon l'invention, la charge étant montée sur les sources,

– figure 4 : schéma de réalisation de l'oscillateur selon l'invention, la charge étant montée sur les drains.

2

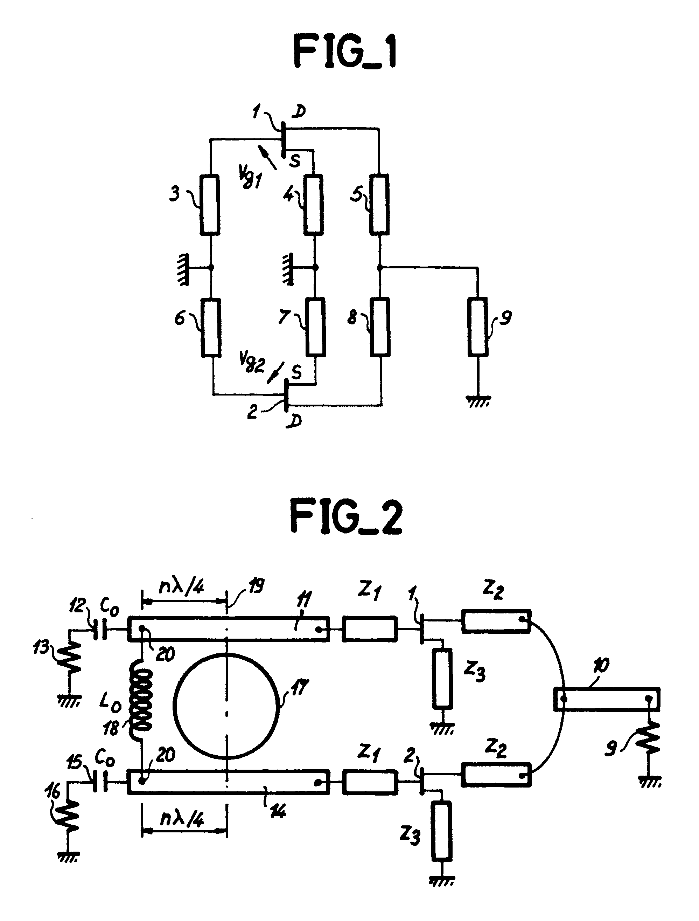

La figure 1 représente le schéma, très simplifié, d'un oscillateur doubleur en montage dit "push-push". Il comprend deux transistors à effet de champ 1 et 2 qui sont montés en parallèle. Les trois électrodes de grille, source et drain de chaque transistor sont réunies à des circuits d'impédance, 3, 4 et 5 pour le premier transistor, 6, 7 et 8 pour le second transistor. Les impédances de grilles et de sources peuvent être mises à la masse, ce qui confère au circuit son caractère en boucle. La charge 9 est connectée au point milieu des impédances 5 et 8 de sorties : si les transistors 1 et 2 oscillent à 15 GHz par exemple, la fréquence d'oscillation dans la charge est double, soit 30 GHz, qui est l'harmonique 2.

Les impédances de grilles 3 et 6 peuvent être constituées chacune par une microbande et un résonateur diélectrique convenablement positionné pour la fréquence désirée. Le résonateur diélectrique peut aussi être commun aux deux microbandes de grilles. Mais cette topologie convertit le bruit basse fréquence en bruit FM proche de la fréquence porteuse car chaque générateur de bruit donne du bruit converti.

Ce schéma est connu : l'invention y apporte des modifications qui permettent de l'améliorer en supprimant le bruit proche de la porteuse.

On appelle $v_{g1}$ et $v_{g2}$ es tensions hyperfréquences de grille -à ne pas confondre avec les tensions de polarisation-et $i_{d1}$ et $i_{d2}$ les courants hyperfréquences de drain, pour les deux transistors 1 et 2. Si les courants $i_{d1}$ et $i_{d2}$ sont en opposition de phase au mode fondamental et en phase à l'harmonique 2, on peut montrer que dans la charge n'existe que l'harmonique 2. En effet :

$$i_{d1} = av_{g1} + bv_{g1}^2 + cv_{g1}^3 + dv_{g1}^4$$

Si les deux transistors sont identiques, ce qui est le cas général, et en opposition de phase au fondamental

$$v_{g2} = -v_{g1}$$

donc

$$i_{d2} = -av_{g1} + bv_{g1}^2 - cv_{g1}^3 + dv_{g1}^4$$

La somme dans la charge est

$$i_d = 2bv_{g1}^2 + 2dv_{g1}^4$$

Par ailleurs

$$v_{g1} = v_g + v_{b1} + v_{b2}$$

dans laquelle :
- $v_g$ est la tension hyperfréquence du transistor au fondamental
- $v_{b1}$ est la tension de bruit basse fréquence due au transistor 1
- $v_{b2}$ est la tension de bruit basse fréquence due au transistor 2.

Lorsque les circuits BF de grilles sont en série la source de bruit basse fréquence du transistor 2 est aussi en série avec la source de bruit basse fréquence du transistor 1, mais si les sources de bruit des transistors ne sont pas corrélées -ce qui est le cas dans l'invention-on a :

$$\overline{v_{b1} \cdot v_{b2}} = 0$$

Si on écrit le courant drain $i_d$ sous une forme plus générale

$$I_d = Av_g^2 + Bv_g^4 = Av_g \sin^2 \omega t + Bv_g^3 \sin^4 \omega t$$

3

(ω étant la pulsation)
on voit que le courant dans la charge comporte des termes en :

$$2\omega_0 \text{ et } 2\omega_0 \pm 2\omega_b$$

$\omega_0$ = pulsation du mode fondamental
$\omega_b$ = pulsation du bruit basse fréquence

Le bruit en $2\omega_0 \pm 2\omega_b$ existe, mais il est plus éloigné de la fréquence porteuse ($2\omega_0$) et moins gênant que le bruit $2\omega_0 \pm \omega_b$ des oscillateurs classiques.

Les sources de bruit basse fréquence non corrélées sont mises en série au moyen d'une self et de deux capacités conformément au schéma de la figure 2, qui représente un oscillateur selon l'invention, dans une forme générale. Cette self BF contribue à donner la condition selon laquelle les générateurs de bruit basse fréquence sont en opposition de phase.

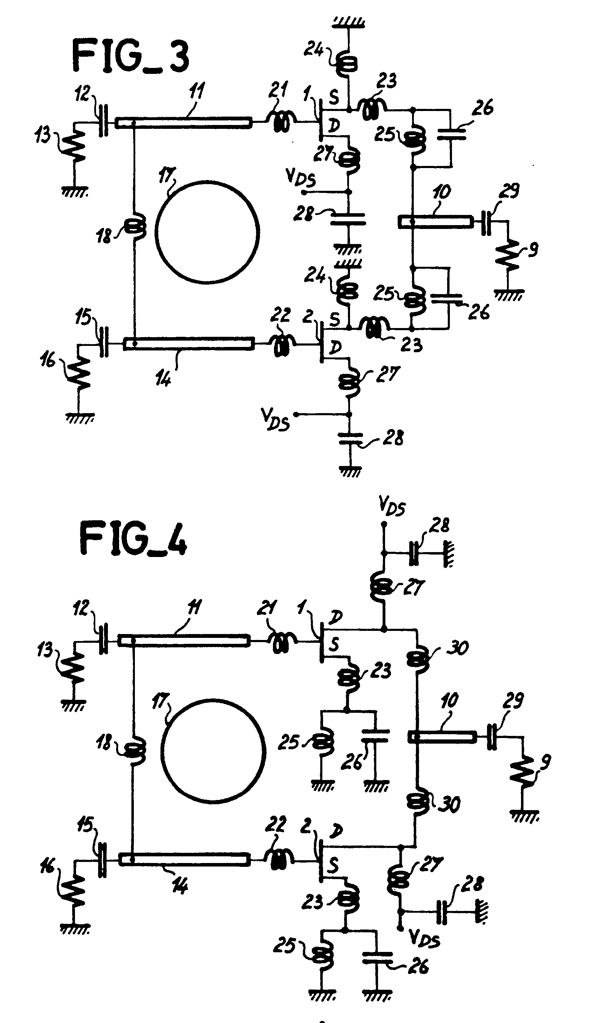

Sur ce schéma, les transistors à effet de champ 1 et 2 ont leurs sources et drains connectés à des impédances $Z_2$ et $Z_3$ dont le détail sera donné ultérieurement, en figures 3 et 4. La charge 9 est réunie au point commun des impédances de sorties $Z_2$ par l'intermédiaire d'une microbande 10.

La grille du premier transistor 1 est réunie par un fil métallique -qui constitue une impédance $Z_1$- à une première extrémité d'une microbande 11, dont la deuxième extrémité est réunie, à travers une capacité 12 de forte valeur $C_0$, à une résistance 13 mise à la masse. De la même façon, la grille du deuxième transistor 2 est réunie par un fil métallique à une microbande 14, une capacité 15 et une résistance 16. Les deux microbandes 11 et 14 sont parallèles entre elles, et un résonateur diélectrique 17 est positionné entre les microbandes 11 et 14 de telle façon que le circuit oscille à la fréquence désirée et que la condition des courants en opposition de phase au fondamental soit remplie. Une self de choc de valeur $L_0$, constituée par un enroulement en fil de cuivre, est montée en pont entre les deux microbandes 11 et 14, et soudée en des points qui seront précisés ultérieurement.

Le résonateur diélectrique 17 couplé aux deux lignes microbandes 11 et 14 donne la condition d'opposition de phase pour $v_{g1}$ et $v_{g2}$, à la fréquence fondamentale. Mais de plus, le résonateur diélectrique 17 est équivalent, dans son plan de couplage 19 avec les microbandes 11 et 14, à un circuit ouvert à sa fréquence de résonance, et à un court-circuit aux autres fréquences. Son influence en basse fréquence est donc quasi-nulle, et les sources de bruit basse fréquence, mises en série par la self de choc 18, se referment entre elles. La self de choc 18, de valeur élevée $L_0$, est équivalente à une impédance de valeur infinie à la fréquence de résonance du résonateur diélectrique 17 : elle n'a donc pas d'action pour les hyperfréquences.

Les deux capacités 12 et 15 de forte valeur $C_0$, par exemple 20 pF, sont nécessaires pour mettre en série les deux sources de bruit. Elles font que le potentiel continu de polarisation des grilles n'est plus référencé par rapport à une masse, mais cela est sans importance car les grilles s'autopolarisent. Par contre, ces deux capacités 12 et 15 permettent de refermer le circuit des sources de bruit.

Pour régler l'oscillateur selon l'invention, on opère d'abord sans self de choc 18. Le résonateur diélectrique 17 est déplacé le long des deux microbandes -et éventuellement transversalement-jusqu'à ce que la fréquence désirée soit obtenue sur la charge 9. La position finale détermine le plan de couplage 19.

Le point 20, en lequel la self 18 doit être soudée sur la microbande 11, ou 14, doit être distant du plan de couplage 19 d'une longueur égale à $\lambda/4$ -$\lambda$ étant la longueur d'onde guidée à la fréquence de travail des transistors- ou multiple de $\lambda/4$ si la fréquence est trop élevée pour qu'il soit possible de souder en 20 un fil, compte tenu de l'encombrement du résonateur 17.

A titre d'exemple, si la fréquence dans la charge est 20 GHz, les transistors travaillent à 10 GHz, $\lambda/4$=2,9 mm et le résonateur 17 a un diamètre de 4 mm : il est possible de faire une soudure en 20 à une distance $\lambda/4$. Si la fréquence dans la charge est 30 GHz, $\lambda/4$=1,9 mm à 15 GHz et le résonateur a un diamètre de 3,4 mm : il est préférable de faire la soudure en 20 à $3\lambda/4$.

Une autre façon de réduire le bruit FM d'un oscillateur est d'avoir les générateurs de bruit BF chargés sur une impédance infinie. C'est une solution intéressante lorsqu'on veut réaliser des oscillateurs de fréquence plus élevée. Dans ce cas, on ne met pas en place la self $L_0$ 18, qui met en série les deux sources de bruit. Les capacités 12 et 15, intercalées entre les entrémités de microbandes de grilles 11 et 14 et les résistances 13 et 16 de mise à la masse, sont équivalentes à un circuit ouvert aux basses fréquences : les sources de bruit sont chargées par une impédance infinie, et il s'ensuit une diminution du bruit.

Le schéma de l'oscillateur, dans cette variante de l'invention, est le même que celui de la figure 2, ou que les figures 3 et 4, mais sans le self $L_0$ 18 de mise en série des sources de bruits.

A 30 GHz, un oscillateur selon l'invention, muni de deux capacités 12 et 15, présente une amélioration de 5 dB par rapport à un oscillateur connu, en montage "push-push" sans ces capacités.

La figure 2 donne le cas général d'un oscillateur doubleur selon l'invention : les électrodes d'accès des transistors 1 et 2 sont couplées à des impédances $Z_2$ et $Z_3$ selon que la charge 9 est branchée sur les sources des transistors (figure 3) ou sur les drains (figure 4).

Dans les deux cas, les impédances $Z_1$ de grilles des transistors 1 et 2 sont constituées par le fil ou ruban métallique de connection sur les microbandes 11 et 14.

Si la charge 9 est couplée aux sources (figure 3), l'impédance $Z_2$ de source est, pour chaque transistor, constituée par une self 23 :
- en parallèle avec une self 24 mise à la masse
- et en série avec un circuit LC parallèle constitué par une self 25 et une capacité 26, ce circuit étant connecté à la microbande 10 de liaison avec la charge 9.

De même, l'impédance $Z_3$ de drain est, pour chaque transistor, constituée par une self 27 en série avec une capacité 28 mise à la masse. La tension de polarisation $V_{DS}$ est appliquée aux transistors au point commun à la self 27 et à la capacité 28.

Une capacité 29, de forte valeur, intercalée entre la microbande 10 et la charge 9, découple la charge de la tension continue de polarisation.

Si la charge 9 est couplée aux drains (figure 4), le schéma est très voisin du précédent.

Les impédances de sources $Z_2$ sont constituées des mêmes selfs 23 et 25 et capacité 26, mais sans la self 27. Le circuit LC 25+26 est mis à la masse.

Les impédances de drain $Z_3$ sont constituées des mêmes self 27 et capacité 28, avec polarisation par une tension $V_{DS}$ appliquée au point commun à la self 27 et à la capacité 28. Mais une self 30 est montée en parallèle avec la self 27 : l'extrémité libre de la self 30 est connectée au microruban 10.

Bien entendu, une capacité 29 de forte valeur (20 pF) découple la charge 9 de la tension continue.

Avec l'oscillateur doubleur selon l'invention, une amélioration de $5dB_c$/Hz à 10 kHz de la porteuse 20 GHz a été obtenue sur le bruit FM, due à la présence de la self 18. Alors que le bruit mesuré à 10 kHz de la porteuse valait -83 $dB_c$/Hz sans self 18, c'est-à-dire dans un montage connu, il vaut -88 $dB_c$/Hz dans un oscillateur selon l'invention, avec self 18 en série entre les microbandes 11 et 14 de grilles, les meilleurs résultats de réduction du bruit FM sont obtenus si la partie imaginaire du résonateur a une pente élevée, et si la fréquence d'oscillation est égale à la fréquence du mode fondamental du résonateur.

L'oscillateur doubleur selon l'invention est utilisé dans les systèmes hyperfréquences de télécommunications, radars, et en électronique professionnelle de traitement de l'information.

## Revendications

1. Oscillateur doubleur de fréquence, fonctionnant en hyperfréquences, comportant, dans un montage dit "push-push", deux transistors (1, 2) à effet de champ travaillant en parallèle, dont les électrodes de sources et drains sont connectées à des impédances ($Z_2$, $Z_3$), la charge d'utilisation (9) étant connectée en un point commun aux impédances ($Z_2$) des électrodes de sortie des deux transistors (1, 2), dont les grilles sont connectées, pour chaque transistor, par une impédance ($Z_1$), à une première extrémité d'une ligne microbande (11, 14) dont la seconde extrémité est mise à la masse par une résistance (13, 16), un résonateur diélectrique (17) étant placé entre les deux lignes microbandes (11, 14) en un point tel que l'oscillation est obtenue, cet oscillateur étant caractérisé en ce que, en vue de diminuer le bruit basse fréquence dans la charge (9) aux environs de la fréquence principale, dite porteuse, les sources de bruit propres aux transistors (1, 2) sont isolées de la masse en courant continu, et chargées par une impédance basse fréquence de valeur infinie, constituée par deux capacités (12, 15) de forte valeur ($C_0$), chacune de ces deux capacités étant interposée entre la seconde extrémité d'une ligne microbande (11, 14) et sa résistance (13, 16) de mise à la masse.

2. Oscillateur doubleur selon la revendication 1, caractérisé en ce que, en vue de mettre en série les sources de bruit non corrélées, l'impédance basse fréquence comporte en outre une self (18) connectée (en 20) aux secondes extrémités des lignes microbandes (11, 14).

3. Oscillateur doubleur selon la revendication 1, caractérisé en ce que, les courants de grilles ($i_{g1}$, $i_{g2}$) des transistors (1, 2) étant en opposition de phase pour le mode fondamental et en phase pour l'harmonique 2, le bruit basse fréquence dans la charge (9) est éloigné de la fréquence porteuse ($2\omega_0$) et a une fréquence définie par $2\omega_0 \pm 2\omega_b$, $\omega_0$ étant la pulsation de mode fondamental et $\omega_b$ la pulsation du bruit basse fréquence.

4. Oscillateur doubleur selon la revendication 1, caractérisé en ce que, le résonateur diélectrique (17) définissant avec les deux lignes microbandes (11, 14) un plan de couplage (19), les extrémités de la self (18) qui met en série les sources de bruit sont soudées sur les secondes extrémités des lignes microbandes (11, 14) en un point (20) distant du plan de couplage (19) d'une longueur multiple de $\lambda/4$, $\lambda$ étant la longueur d'onde guidée du mode fondamental.

5. Oscillateur doubleur selon l'une quelconque des revendications 1 à 4, caractérisé en ce que la charge (9) est connectée sur les circuits ($Z_2$) des sources des transistors (1, 2).

6. Oscillateur doubleur selon l'une quelconque des revendications 1 à 4, caractérisé en ce que la charge (9) est connectée sur les circuits ($Z_3$) de drains des transistors (1, 2).

## Ansprüche

1. Frequenzverdoppler-Oszillator, der im Ultrahochfrequenzbereich arbeitet und in einer sogenannten "Push-Push"-Schaltung zwei parallel arbeitende Feldeffekttransistoren (1, 2) umfaßt, deren Source- und Drain-Elektroden mit Impedanzen ($Z_2$, $Z_3$) verbunden sind, wobei die Nutzlast (9) mit einem den Impedanzen ($Z_2$) der Ausgangselektroden der zwei Transistoren (1, 2) gemeinsamen Punkt verbunden sind, und deren Gates jeweils über eine Impedanz ($Z_1$) mit einem ersten Ende eines Mikrostreifenleiters (11, 14) verbunden sind, dessen zweites Ende jeweils über einen Widerstand (13, 16) geerdet ist, wobei ein dielektrischer Resonator (17) zwischen den zwei Mikrostreifenleitern (11, 14) an einem Punkt, an dem die Schwingung erhalten wird, angeordnet ist und wobei dieser Oszillator dadurch gekennzeichnet ist, daß im Hinblick auf eine Absenkung des Niederfrequenzrauschens in der Last (9) in der Umgebung der Hauptfrequenz, der sogenannten Trägerfrequenz, die Quellen des Eigenrauschens der Transistoren (1, 2) bei Gleichstrom gegenüber Erde isoliert sind und über eine niederfrequente Impedanz von unendlichem Wert geladen werden, wobei die Impedanz von zwei Kapazitäten (12, 15) mit hohem Wert ($Z_0$) gebildet wird, wobei jede dieser zwei Kapazitäten zwischen das zweite Ende eines Mikrostreifenleiters (11, 14) und ihren Erdungswiderstand (13, 16) eingesetzt ist.

2. Verdoppler-Oszillator gemäß Anspruch 1, dadurch gekennzeichnet, daß im Hinblick auf eine Reihenschaltung der nicht korrelierten Rauschquellen die niederfrequente Impedanz außerdem eine Drosselspule (18) umfaßt, die (in 20) mit den zweiten Enden der Mikrostreifenleiter (11, 14) verbunden ist.

3. Verdoppler-Oszillator gemäß Anspruch 1, dadurch gekennzeicht, daß das niederfrequente Rauschen in der Last (9) von der Trägerfrequenz ($2\omega_0$) entfernt ist und eine durch $2\omega_0 \pm 2\omega_b$ definierte Frequenz besitzt, wobei $\omega_0$ die Schwingung der Grundmode und $\omega_b$ die Schwingung des niederfrequenten Rauschens ist und wobei die Gateströme ($i_{g1}$, $i_{g2}$) der Transistoren (1, 2) in der Grundmode gegenphasig und in der 2. Harmonischen gleichphasig sind.

4. Verdoppler-Oszillator gemäß Anspruch 1, dadurch gekennzeichnet, daß dann, wenn der dielektrische Resonator (17) mit den zwei Mikrostreifenleitern (11, 14) eine Kopplungsebene (19) definiert, die Enden der Drosselspule (18), die die Rauschquellen in Reihe schaltet, an den zweiten Enden der Mikrostreifenleiter (11, 14) an einem Punkt (20), der sich von der Kopplungsebene (19) in einem Abstand befindet, der gleich einem Vielfachen von $\lambda/4$ ist, wobei $\lambda$ die von der Grundmode geführte Wellenlänge ist, verschweißt sind.

5. Verdoppler-Oszillator gemäß einem der Ansprüche 1 bis 4, dadurch gekennzeichnet, daß die Last (9) mit den Schaltungen ($Z_2$) der Sources der Transistoren (1, 2) verbunden ist.

6. Verdoppler-Oszillator gemäß einem der Ansprüche 1 bis 4, dadurch gekennzeichnet, daß die Last (9) mit den Schaltungen (Z3) der Drains der Transistoren (1, 2) verbunden ist.

## Claims

1. A frequency doubling oscillator functioning in the microwave range, comprising, in a "push-push" configuration, two field effect transistors (1 and 2) operating in parallel, whose source and drain electrodes are connected with impedances ($Z_2$ and $Z_3$), the working load (9) being connected with a point common to the impedances ($Z_2$) of the output electrodes of two transistors (1 and 2), whose gates are connected, for each transistor, by an impedance ($Z_1$), with a first end of a strip transmission line (11 and 14) whose second end is grounded through a resistor (13 and 16), a dielectric resonator (17) being placed between the two strip transmission lines (11 and 14) at a point such that oscillation is caused, said oscillator being characterized in that in order to diminish the low frequency noise in the load (9) adjacent to the principal frequency, termed the carrier frequency, the noise sources appertaining to the transistors (1 and 2) are separated from ground with respect to DC, and loaded by a low frequency impedance with an infinite value, constituted by two capacitors (12 and 15) with a large value ($C_0$), each of these two said capacitors being placed between the second end of a strip transmission line (11 and 14) and its resistor (13 and 16) for connection with ground.

2. The frequency doubling oscillator as claimed in claim 1, characterized in that in order to place the non-correlated noise sources in series the low frequency impedance furthermore comprises an inductance (18) connected (at 20) with the second ends of the strip transmission lines (11 and 14).

3. The frequency doubling oscillator as claimed in claim 1, characterized in that, the currents of the gates ($i_{g1}$ and $i_{g2}$) of the transistors (1 and 2) being opposite in phase to each other for the fundamental mode and in phase for the harmonic 2, the low frequency noise in the load (9) is spaced from the carrier frequency ($2\omega_0$) and has a frequency defined by $2\omega_0 \pm 2\omega_b$, wherein $\omega_0$ is the fundamental mode pulsation and $\omega_b$ is the low frequency noise pulsation.

4. The frequency doubling oscillator as claimed in claim 1, characterized in that, the dielectric resonator (17) and the two strip transmission lines (11 and 14) together defining a coupling zone (19), the ends of the inductance (18), which place the noise sources in series, are soldered or welded to the second ends of the strip transmission lines (11 and 14) at a point (20) spaced from the coupling zone (19) by a length which is a multiple of $\lambda/4$, $\lambda$ being the fundamental wavelength which is guided.

5. The frequency doubling oscillator as claimed in any one of the preceding claims 1 through 4, characterized in that the load (9) is connected to the circuits ($Z_2$) of the sources of the transistors (1 and 2).

6. The frequency doubling oscillator as claimed in any one of the preceding claims 1 through 4, characterized in that the load (9) is connected with the circuits ($Z_3$) of the drains of the transistors (1 and 2).

# FIG_1

# FIG_2

# FIG_3

# FIG_4